# EUROPEAN PATENT APPLICATION

(11) **EP 4 106 024 A1**
(43) Date of publication of application: **21.12.2022**
(21) Application number: 21180259.0
(22) Date of filing: 18.06.2021
(51) Int. Cl.: H01L 51/00, H01L 51/54

(54) **METHOD FOR PREPARATION OF A P-TYPE SEMICONDUCTING LAYER, P-TYPE SEMICONDUCTING LAYER OBTAINED BY SAID METHOD, ORGANIC ELECTRONIC DEVICE COMPRISING THE P-TYPE SEMICONDUCTING LAYER, DISPLAY DEVICE COMPRISING THE ORGANIC ELECTRONIC DEVICE, METAL COMPOUND AND USE OF SAID METAL COMPOUND FOR THE P-TYPE SEMICONDUCTING LAYER**

(71) Applicant: Novaled GmbH, 01099 Dresden (DE)
(72) Inventor: UVAROV, Vladimir, 01099 Dresden (DE); HEGGEMANN, Ulrich, 01099 Dresden (DE); WILLMANN, Steffen, 01099 Dresden (DE)
(74) Representative: Michalski Hüttermann & Partner Patentanwälte mbB

(57) **Abstract**

The present invention relates to a method for preparation of a p-type semiconducting layer, a p-type semiconducting layer obtained by said method, an organic electronic device comprising the p-type semiconducting layer, a display device comprising the organic electronic device, a metal compound and a use of said metal compound for the p-type semiconducting layer.

## Description

### Technical Field

The present invention relates to a method for preparation of a p-type semiconducting layer, a p-type semiconducting layer obtained by said method, an organic electronic device comprising the p-type semiconducting layer, a display device comprising the organic electronic device, a metal compound and a use of said metal compound for the p-type semiconducting layer.

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the semiconductor layer, and among them, may be affected by characteristics of metal complexes which are also contained in the semiconductor layer.

Production of organic electronic devices inter alia comprises the preparation of p-type semiconduction layers. The preparation of said layers may be affected by the characteristics of the compounds used in the p-type semiconducting layers.

There remains a need to improve the methods for preparation of p-type semiconducting layers, in particular to achieve a more robust process for mass production of organic electronic devices with excellent properties.

### DISCLOSURE

An aspect of the present invention provides a method preparation of a p-type semiconducting layer, the method comprising at least the following steps:
(a) Providing a surface;
(b) Providing p-type semiconducting material comprising a metal compound, the metal compound having a hygroscopy of ≤ 4%;
(c) Evaporating the metal compound at a reduced pressure;
(d) Depositing the evaporated metal compound on the surface.

In the present specification, the term "hygroscopy" relates to the relative weight gain due to sorption of water of a dried sample, particularly by a dried sample under specified conditions.

In the present specification, when a definition is not otherwise provided, "partially fluorinated" refers to a C₁ to C₈ alkyl group in which only part of the hydrogen atoms are replaced by fluorine atoms.

In the present specification, when a definition is not otherwise provided, "perfluorinated" refers to a C₁ to C₈ alkyl group in which all hydrogen atoms are replaced by fluorine atoms.

In the present specification, when a definition is not otherwise provided, "substituted" refers to one substituted with a deuterium, C₁ to C₁₂ alkyl and C₁ to C₁₂ alkoxy.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a C₁ to C₁₂ alkyl group. More specifically, the alkyl group may be a C₁ to C₁₀ alkyl group or a C₁ to C₆ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphtyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common sp²-hybridized carbon atoms

In the present specification, the single bond refers to a direct bond. The term "free of', "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The terms "cathode", "cathode layer" and "cathode electrode" are used synonymously.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

### Advantageous Effects

Surprisingly, it was found that the method of the present invention solves the problem underlying the present invention by enabling a more robust process for mass production of organic electronic devices with excellent properties.

According to one embodiment of the present invention, the metal compound is capable of reducing the voltage of an organic light-emitting device at a certain current density when present.

According to one embodiment of the present invention, the metal compound has a hygroscopy of ≤ 3%, more preferably ≤ 2%, even more preferably ≤ 1%, even more preferably ≤ 0.5% by, most preferably ≤ 0.2%.

According to one embodiment of the present invention, the hygroscopy is the relative weight gain determined by gravimetric measurement of a vacuum dried sample of the metal compound, exposed to 70 ± 4 % relative humidity at 23 ± 2 °C for one hour.

According to one embodiment of the present invention, the metal compound has a relative water content due to sorption of ≤ 4% by weight, preferably ≤ 3% by weight, more preferably ≤ 2% by weight, even more preferably ≤ 1% by weight, even more preferably ≤ 0.5% by weight, most preferably ≤ 0.2% by weight.

According to one embodiment of the present invention, the relative water content due to sorption is measured by Karl Fischer titration.

According to one embodiment of the present invention, the water content is measured for a vacuum dried sample of the metal compound that has been exposed to 70 ± 4 % relative humidity at 23 ± 2 °C for one hour.

According to one embodiment of the present invention, the metal compound is air stable.

The term "air stable" in the present specification refers to compounds that are stable towards oxidation and/or hydrolysis when subjected to humid air. Oxidation is the increase of the oxidation number of the metal compound's metal. Hydrolysis is the release of a ligand by chemical reaction of the complex with water. Neutral ligands can be released unchanged, anionic ligands may be released in form of their conjugated acids.

Particularly, the metal compound is considered air stable in the context of the present specification if an analytical assay method for oxidation and/or hydrolysis of the metal compound yields a relative change between the vacuum dried metal compound and the metal compound after being exposed to 70 ± 4 % relative humidity at 23 ± 2 °C for one hour, of ≤ 0.5 %, preferably ≤ 0.3 %, more preferably ≤ 0.2 %, even more preferably ≤ 0.1 %, most preferably ≤ 0.05 %, based on the sample dry weight at the start of the standardized hygroscopicity test.

According to one embodiment of the present invention, at least 20 %, alternatively at least 25%, alternatively at least 30 %, alternatively at least 40 %, alternatively at least 50%, alternatively at least 66 %, preferably at least 75 %, more preferably at least 80 %, even more preferably at least 90 %, most preferably 100 % of the overall number of peripheral atoms present in the metal compound are independently selected from F, Cl, Br, I and N, preferably from F and N, wherein peripheral atoms are all atoms which are covalently bound to a single neighbour atom.

According to one embodiment of the present application, the metal compound comprises a metal cation and at least one ligand.

According to one embodiment of the present application, the metal compound comprises a metal cation in an oxidation state +I, +II, + III or + IV and at least one ligand.

According to one embodiment of the present application, the metal compound comprises a metal cation in an oxidation state +I, +II, + III or + IV and at least one monoanionic ligand.

According to one embodiment of the present application, the metal compound comprises a metal in an oxidation state of +1 and a monoanionic ligand.

In the present specification, the term "ligand" refers to an anionic or neutral molecule which binds to a cationic metal either by a dative bond or ionic interaction when the ligand is anionic, preferably a dative bond, wherein the nature of the dative bond can have a character ranging from a covalent bond to an ionic bond.

According to one embodiment of the present application, the metal compound comprises at least one ligand, and the ligand, preferably all ligands, consists of elements selected from from H, F, Cl, Br, I, C, Si, O, S, N and P.

According to one embodiment of the present application, the metal compound is selected from the following structures E1-E32:

| Compound | Structure | Name |
|---|---|---|
| E1 | 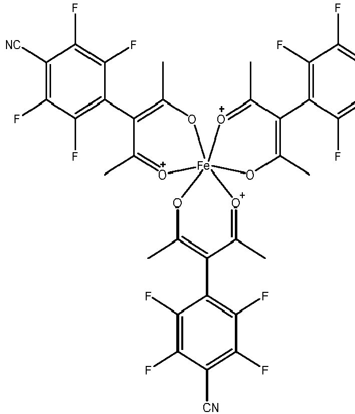 | Tris(3-(4-cyano-2,3,5,6-tetrafluorophenyl)-2, 4-pentanedionato)iron(III) |
| E2 | 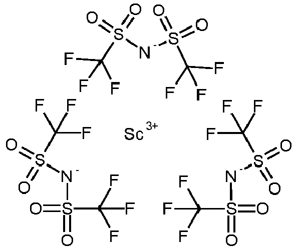 | Scandium(III) bistriflylimide |
| E3 | 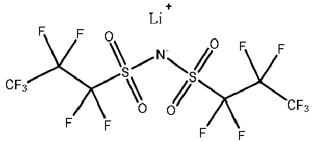 | lithium bis((perfluoropropyl)sulfonyl)amide |
| E4 | 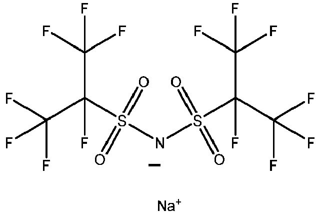 | sodium bis((perfluoropropan-2-yl)sulfonyl)amide |
| E5 | 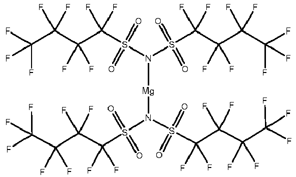 | magnesium bis((perfluorobutyl)sulfonyl)amide |
| E6 | 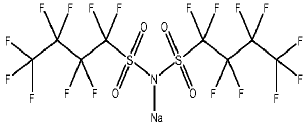 | 1-Butanesulfonamide, 1,1,2,2,3,3,4,4,4-nonafluoro-*N*-[(1,1,2,2,3,3,4,4,4-nonafluorobutyl)sulfonyl]-, sodium salt |
| E7 | 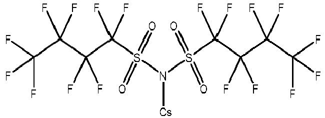 | 1-Butanesulfonamide, 1,1,2,2,3,3,4,4,4-nonafluoro-*N*-[(1,1,2,2,3,3,4,4,4-nonafluorobutyl)sulfonyl]-, Cesium salt |
| E8 | 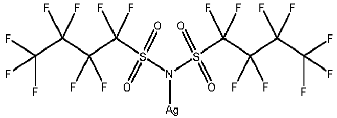 | 1-Butanesulfonamide, 1,1,2,2,3,3,4,4,4-nonafluoro-*N*-[(1,1,2,2,3,3,4,4,4-nonafluorobutyl)sulfonyl]-, silver |
| E9 | 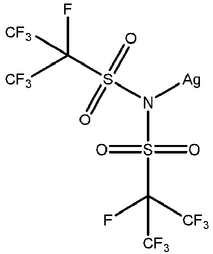 | ((1,1,1,2,3,3,3-heptafluoro-N-((perfluoropropan-2-yl)sulfonyl)propan-2-yl)sulfonamido)silver |
| E10 | 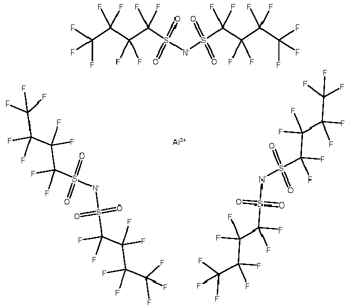 | aluminium tris(bis(perfluorobutyl)sulfonyl)amide) |
| E11 | 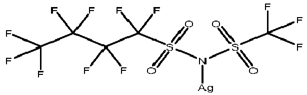 | ((1,1,2,2,3,3,4,4,4-nonafluoro-N-((trifluoromethyl)sulfonyl)butyl)sulfona mido)silver |
| E12 | 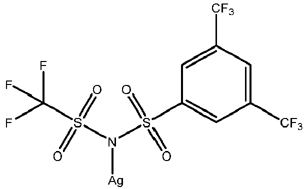 | ((3,5-bis(trifluoromethyl)-N-((trifluoromethyl)sulfonyl)phenyl)sulfona mido)silver |
| E13 | 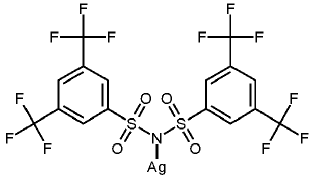 | ((N-((2,4-bis(trifluoromethyl)phenyl)sulfinyl)-3,5-bis(trifluoromethyl)phenyl)sulfonamido)s ilver |
| E14 | 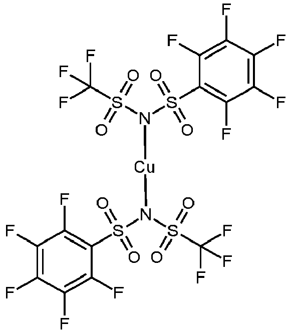 | bis((1,1,1-trifluoro-N-((perfluorophenyl)sulfinyl)methyl)sulfon amido)copper |
| E15 | 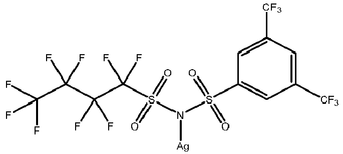 | ((N-((perfluorobutyl)sulfonyl)-3,5-bis(trifluoromethyl)phenyl)sulfonamido)s ilver |
| E16 | 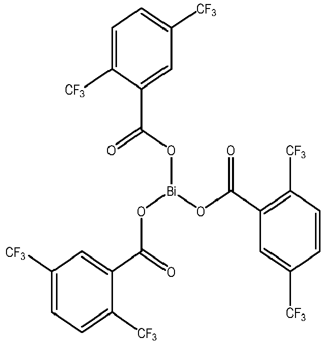 | bismuthanetriyltris(oxy))tris((2,5-bis(trifluoromethyl)phenyl)methanone) |
| E17 | 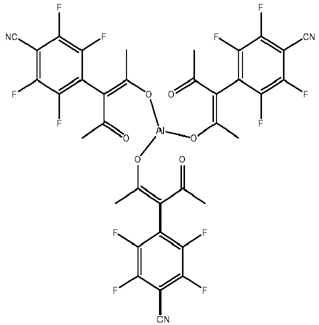 | tris(((Z)-3-(4-cyano-2,3,5,6-tetrafluorophenyl)-4-oxopent-2-en-2-yl)oxy)aluminum |
| E18 | 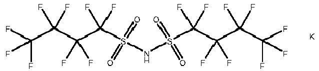 | 1,1,2,2,3,3,4,4,4-nonafluoro-N-((perfluorobutyl)sulfonyl)butane-1-sulfonamide, potassium salt |
| E19 | 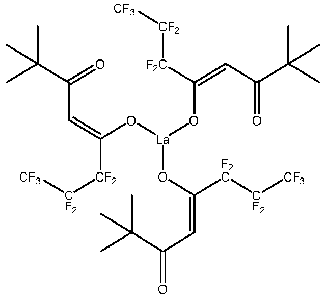 | tris(((Z)-1,1,1,2,2,3,3-heptafluoro-7,7-dimethyl-6-oxooct-4-en-4-yl)oxy)lanthanum |
| E20 | 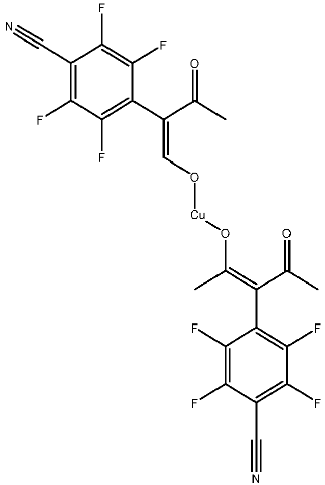 | (((Z)-2-(4-cyano-2,3,5,6-tetrafluorophenyl)-3-oxobut-1-en-1-yl)oxy)(((Z)-3-(4-cyano-2,3,5,6-tetrafluorophenyl)-4-oxopent-2-en-2-yl)oxy)copper |
| E21 | 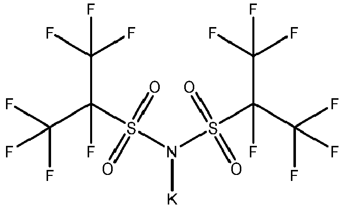 | potassium bis((perfluoropropan-2-yl)sulfonyl)amide |
| E22 | 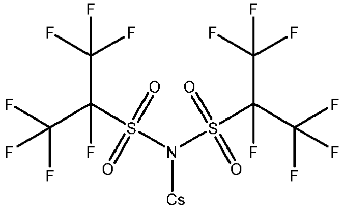 | cesium bis((perfluoropropan-2-yl)sulfonyl)amid |
| E23 | 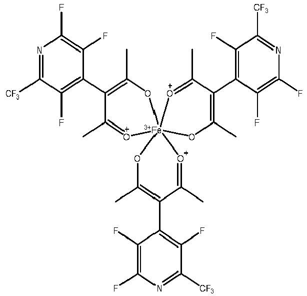 | tris(((Z)-4-oxo-3-(2,3,5-trifluoro-6-(trifluoromethyl)pyridin-4-yl)pent-2-en-2-yl)oxy)iron |
| E24 | 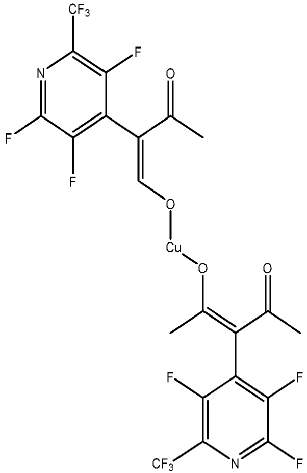 | (((Z)-3-oxo-2-(2,3,5-trifluoro-6-(trifluoromethyl)pyridin-4-yl)but-1-en-1-yl)oxy)(((Z)-4-oxo-3-(2,3,5-trifluoro-6-(trifluoromethyl)pyridin-4-yl)pent-2-en-2-yl)oxy)copper |
| E25 | 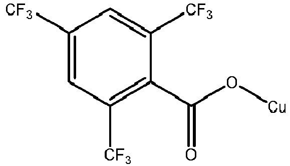 | ((2,4,6-tris(trifluoromethyl)benzoyl)oxy)copper |
| E26 | 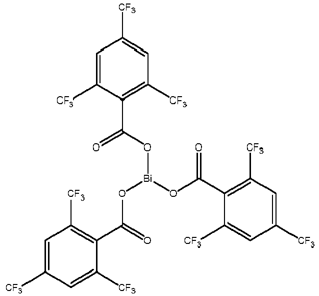 | (bismuthanetriyltris(oxy))tris((2,4,6-tris(trifluoromethyl)phenyl)methanone) |
| E27 | 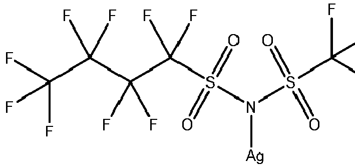 | ((1,1,2,2,3,3,4,4,4-nonafluoro-N-((perfluoropropan-2-yl)sulfonyl)butyl)sulfonamido)silver |
| E28 | 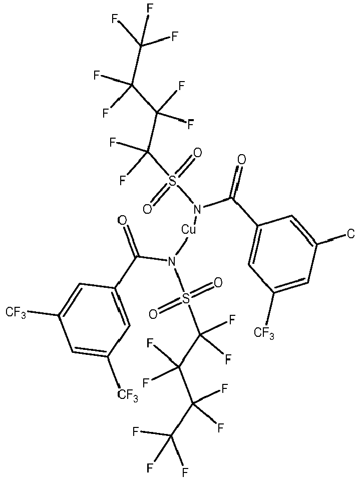 | bis(N-((perfluorobutyl)sulfonyl)-3,5-bis(trifluoromethyl)benzamido)copper |
| E29 | 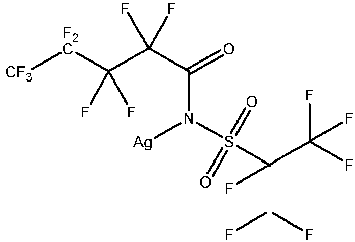 | (2,2,3,3,4,4,5,5,5-nonafluoro-N-((perfluoropropan-2-yl)sulfonyl)pentanamido)silver |
| E31 | 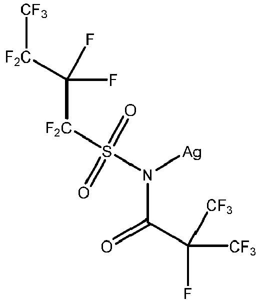 | (2,3,3,3-tetrafluoro-N-((perfluorobutyl)sulfonyl)-2-(trifluoromethyl)propanamido)silver |
| E32 | 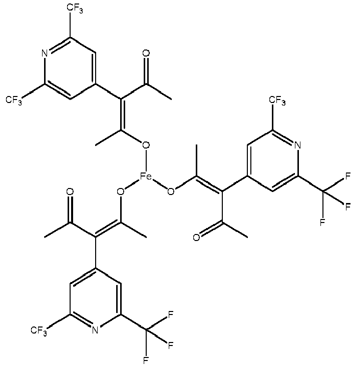 | tris(((Z)-3-(2,6-bis(trifluoromethyl)pyridin-4-yl)-4-oxopent-2-en-2-yl)oxy)iron |

According to one embodiment of the present invention, the evaporation of the metal compound in step (c) is performed at an evaporation temperature of ≥ 100 °C and preferably ≤ 300 °C, more preferably ≥ 110 °C, more preferably ≥ 120 °C, more preferably ≥ 130 °C, more preferably ≥ 140 °C, more preferably ≥ 150 °C, more preferably ≥ 160 °C and most preferably ≥ 165 °C

According to one embodiment of the present invention, the evaporation of the metal compound in step (c) is performed at a reduced pressure of ≤ 10⁻¹ Pa, more preferably ≤ 10⁻² Pa, even more preferably ≤ 10⁻³ Pa, most preferably ≤ 10⁻⁴ Pa.

According to one embodiment of the present invention, the evaporation of the metal compound in step (c) is performed for a duration of ≥ 100 h, preferably ≥ 150 h, more preferably ≥ 200 h.

According to one embodiment of the present invention, the surface in step (a) is an anode layer, a photoactive layer or emission layer, or a hole transport layer.

According to one embodiment of the present invention, the surface in step (a) is an anode layer or a hole transport layer.

According to one embodiment of the present invention, the surface in step (a) is an anode layer.

According to one embodiment of the present invention, the anode layer comprises a first anode sub-layer and a second anode sub-layer, wherein
- the first anode sub-layer comprises a first metal having a work function in the range of ≥ 4 and ≤ 6 eV, and
- the second anode sub-layer comprises a transparent conductive oxide; and
- the second anode sub-layer is arranged closer to the hole injection layer.

According to one embodiment of the present invention, the first metal of the first anode sub-layer may be selected from the group comprising Ag, Mg, Al, Cr, Pt, Au, Pd, Ni, Nd, Ir, preferably Ag, Au or Al, and more preferred Ag.

According to one embodiment of the present invention, the first anode sub-layer has have a thickness in the range of 5 to 200 nm, alternatively 8 to 180 nm, alternatively 8 to 150 nm, alternatively 100 to 150 nm.

According to one embodiment of the present invention, the first anode sub-layer is formed by depositing the first metal via vacuum thermal evaporation.

It is to be understood that the first anode layer is not part of the substrate.

According to one embodiment of the present invention, the transparent conductive oxide of the second anode sub layer is selected from the group selected from the group comprising indium tin oxide or indium zinc oxide, more preferred indium tin oxide.

According to one embodiment of the present invention, the second anode sub-layer may has a thickness in the range of 3 to 200 nm, alternatively 3 to 180 nm, alternatively 3 to 150 nm, alternatively 3 to 20 nm.

According to one embodiment of the present invention, the second anode sub-layer may be formed by sputtering of the transparent conductive oxide.

According to one embodiment of the present invention, anode layer of the organic electronic device comprises in addition a third anode sub-layer comprising a transparent conductive oxide, wherein the third anode sub-layer is arranged between the substrate and the first anode sub-layer.

According to one embodiment of the present invention, the third anode sub-layer comprises a transparent oxide, preferably from the group selected from the group comprising indium tin oxide or indium zinc oxide, more preferred indium tin oxide.

According to one embodiment of the present invention, the third anode sub-layer may have a thickness in the range of 3 to 200 nm, alternatively 3 to 180 nm, alternatively 3 to 150 nm, alternatively 3 to 20 nm.

According to one embodiment of the present invention, the third anode sub-layer may be formed by sputtering of the transparent conductive oxide.

It is to be understood that the third anode layer is not part of the substrate.

According to one embodiment of the present invention, the anode layer comprises a first anode sub-layer comprising of Ag, a second anode sub-layer comprising of transparent conductive oxide, preferably ITO, and a third anode sub-layer comprising of transparent conductive oxide, preferably ITO; wherein the first anode sub-layer is arranged between the second and the third anode sub-layer.

According to one embodiment of the present invention, the p-type semiconducting material further comprises a substantially covalent matrix compound.

### Substantially covalent matrix compound

The p-type semiconducting material may further comprises a substantially covalent matrix compound. According to one embodiment the substantially covalent matrix compound may be selected from at least one organic compound. The substantially covalent matrix may consists substantially from covalently bound C, H, O, N, S, which optionally comprise in addition covalently bound B, P, As and/or Se.

According to one embodiment, the organic semiconductor layer further comprises a substantially covalent matrix compound, wherein the substantially covalent matrix compound may be selected from organic compounds consisting substantially from covalently bound C, H, O, N, S, which optionally comprise in addition covalently bound B, P, As and/or Se.

Organometallic compounds comprising covalent bonds carbon-metal, metal complexes comprising organic ligands and metal salts of organic acids are further examples of organic compounds that may serve as substantially covalent matrix compounds of the hole injection layer.

In one embodiment, the substantially covalent matrix compound lacks metal atoms and majority of its skeletal atoms may be selected from C, O, S, N. Alternatively, the substantially covalent matrix compound lacks metal atoms and majority of its skeletal atoms may be selected from C and N.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

Preferably, the substantially covalent matrix compound comprises at least one arylamine moiety, alternatively a diarylamine moiety, alternatively a triarylamine moiety.

Preferably, the substantially covalent matrix compound is free of metals and/or ionic bonds.

### Compound of formula (VI) or a compound of formula (VII)

According to another aspect of the present invention, the at least one matrix compound, also referred to as "substantially covalent matrix compound", may comprises at least one arylamine compound, diarylamine compound, triarylamine compound, a compound of formula (VI) or a compound of formula (VII) 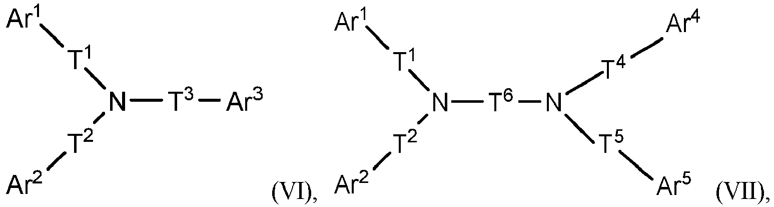 wherein:
T¹, T², T³, T⁴ and T⁵ are independently selected from a single bond, phenylene, biphenylene, terphenylene or naphthenylene, preferably a single bond or phenylene;
T⁶ is phenylene, biphenylene, terphenylene or naphthenylene;
Ar¹, Ar², Ar³, Ar⁴ and Ar⁵ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of Ar¹, Ar², Ar³, Ar⁴ and Ar⁵ are selected the same or different from the group comprising H, D, F, C(=O)R^{2 2}, CN, Si(R²)₃, P(=O)(R²)₂, OR², S(=O)R², S(=O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl.

According to an embodiment wherein T¹, T², T³, T⁴ and T⁵ may be independently selected from a single bond, phenylene, biphenylene or terphenylene. According to an embodiment wherein T¹, T², T³, T⁴ and T⁵ may be independently selected from phenylene, biphenylene or terphenylene and one of T¹, T², T³, T⁴ and T⁵ are a single bond. According to an embodiment wherein T¹, T², T³, T⁴ and T⁵ may be independently selected from phenylene or biphenylene and one of T¹, T², T³, T⁴ and T⁵ are a single bond. According to an embodiment wherein T¹, T², T³, T⁴ and T⁵ may be independently selected from phenylene or biphenylene and two of T¹, T², T³, T⁴ and T⁵ are a single bond.

According to an embodiment wherein T¹, T² and T³ may be independently selected from phenylene and one of T¹, T² and T³ are a single bond. According to an embodiment wherein T¹, T² and T³ may be independently selected from phenylene and two of T¹ T² and T³ are a single bond.

According to an embodiment wherein T⁶ may be phenylene, biphenylene, terphenylene. According to an embodiment wherein T⁶ may be phenylene. According to an embodiment wherein T⁶ may be biphenylene. According to an embodiment wherein T⁶ may be terphenylene.

According to an embodiment wherein Ar¹, Ar², Ar³, Ar⁴ and Ar⁵ may be independently selected from D1 to D16: 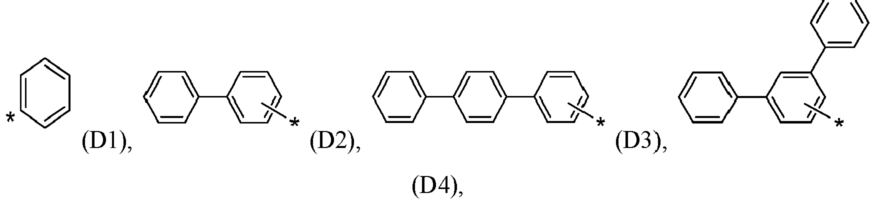 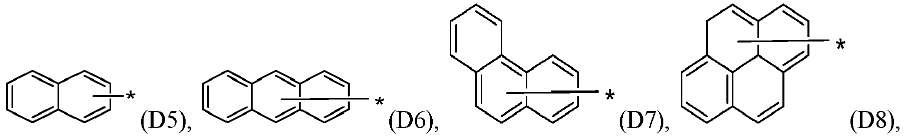 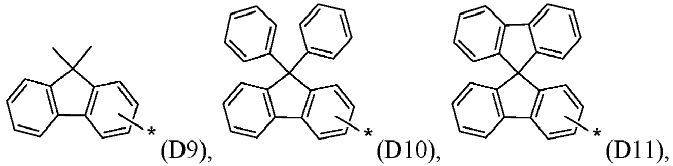 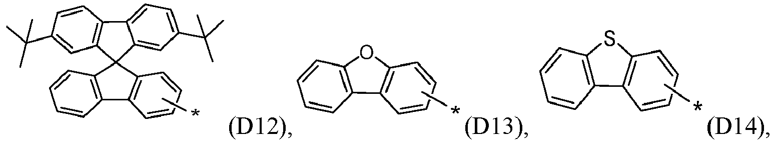 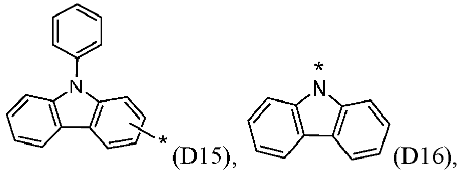 wherein the asterix "*" denotes the binding position.

According to an embodiment, wherein Ar¹, Ar², Ar³, Ar⁴ and Ar⁵ may be independently selected from D1 to D15; alternatively selected from D1 to D10 and D13 to D15.

According to an embodiment, wherein Ar¹, Ar², Ar³, Ar⁴ and Ar⁵ may be independently selected from the group consisting of D1, D2, D5, D7, D9, D10, D13 to D16.

The rate onset temperature may be in a range particularly suited to mass production, when Ar¹, Ar², Ar³, Ar⁴ and Ar⁵ are selected in this range.

The "matrix compound of formula (VI) or formula (VII)" may be also referred to as "hole transport compound".

According to one embodiment, the substantially covalent matrix compound comprises at least one naphthyl group, carbazole group, dibenzofuran group, dibenzothiophene group and/or substituted fluorenyl group, wherein the substituents are independently selected from methyl, phenyl or fluorenyl.

According to an embodiment of the electronic device, wherein the matrix compound of formula (VI) or formula (VII) are selected from F1 to F18:

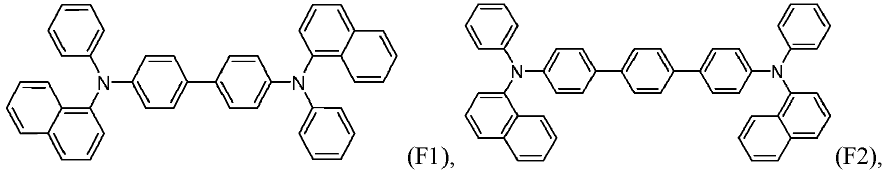

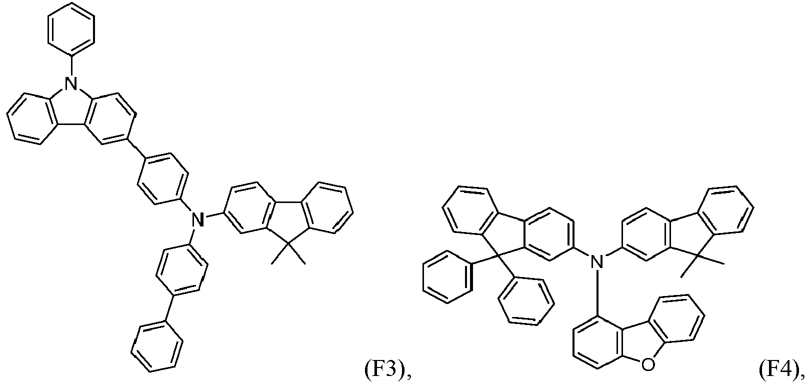

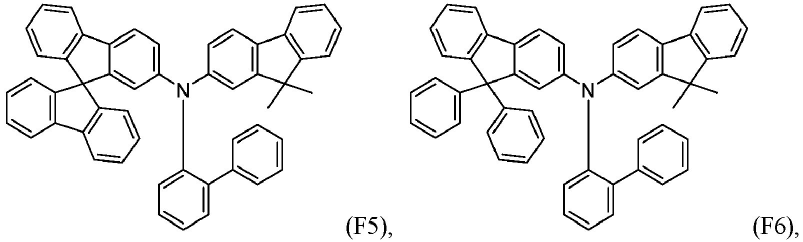

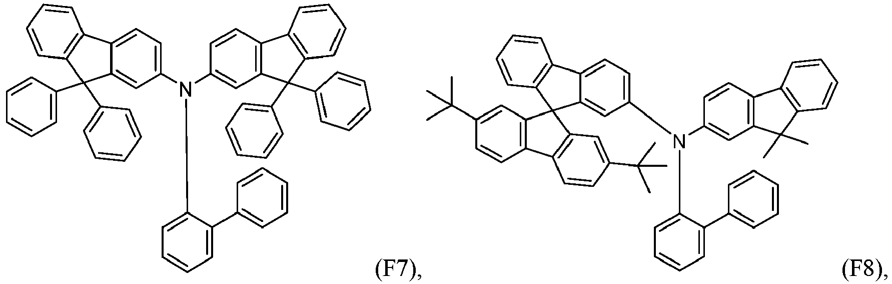

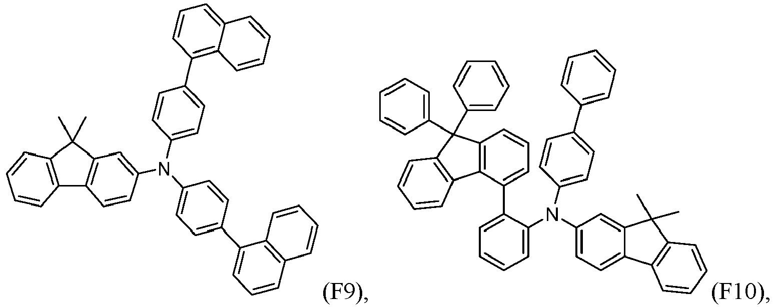

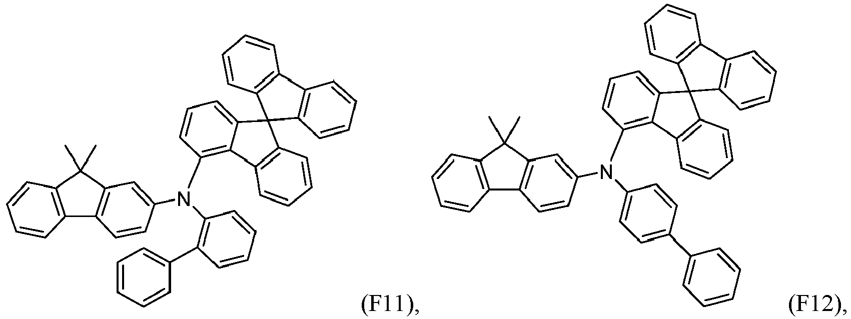

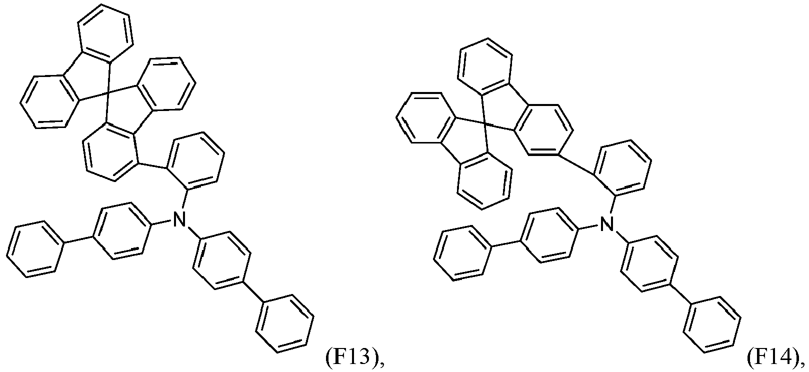

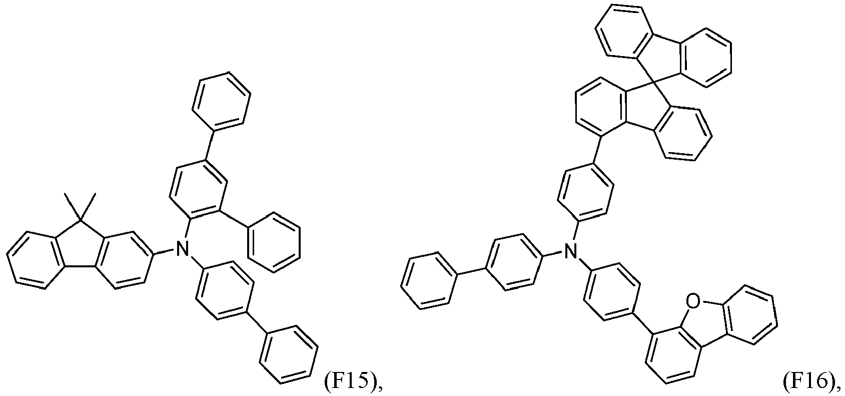

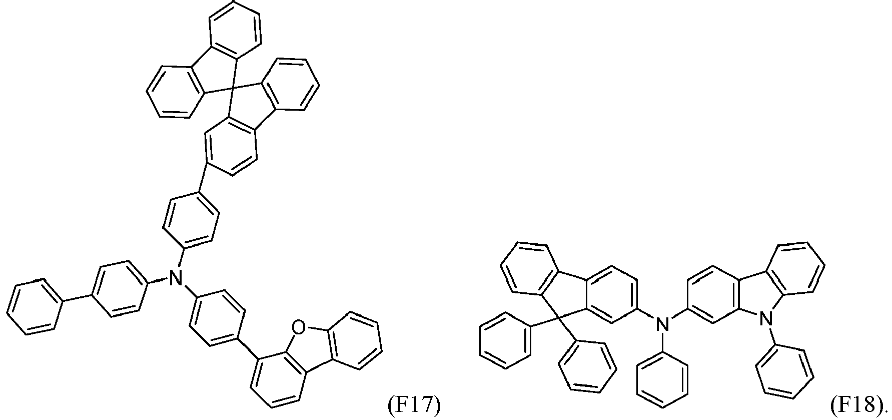

According to one embodiment of the present invention, the p-type semiconducting material does not comprise phtalocyanines, in particular either of copper phtalocyanine and zinc phtalocyanine.

According to one embodiment of the present invention, the p-type semiconducting material does not comprise dithiolenes, in particular molybdenum tris-[1,2-bis(trifluoromethly)ethane-1,2-dithiolene].

According to one embodiment of the present invention, the p-type semiconducting material does not comprise Aluminium-tris(8-hydroxychinolin) (Alq3).

According to one embodiment of the present invention, the p-type semiconducting material does not comprise metal borates.

The present invention furthermore relates to a p-type semiconducting layer, obtained by the method according to the present invention.

According to one embodiment of the present invention the p-type semiconductor layer is non-emissive.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

According to one embodiment of the present invention, the p-type semiconductor layer is a hole injection layer, a hole transport layer or a hole generating layer.

According to one embodiment of the present invention, the p-type semiconductor layer is arranged between an anode and an emission layer. Particularly, according to on embodiment of the present invention, the p-type semiconductor layer is a hole injection layer.

According to one embodiment of the present invention, the p-type semiconductor layer is arranged between a cathode and an emission layer. Particularly, according to one embodiment of the invention, the p-type semiconductor layer is a charge generation layer, preferably a p-type charge generation layer.

According to one embodiment of the present invention, the p-type semiconductor layer is arranged between a first light emitting layer and a second light emitting layer. Particularly, the p-type semiconductor layer is a hole generating layer.

The present invention furthermore relates to an organic electronic device comprising an anode layer, a cathode layer, at least one p-type semiconducting layer according to the present invention, and at least one photoactive layer, wherein the at least one photoactive layer is arranged between the anode layer and the cathode layer.

According to one embodiment of the present invention, the at least one p-type semiconducting layer is arranged between the anode layer and the at least one photoactive layer.

According to one embodiment of the present invention, the organic electronic device comprises a first light emitting layer and a second light emitting layer as photoactive layers, wherein the p-type semiconducting layer is a hole generating layer arranged between the first light emitting layer and the second light emitting layer.

According to one embodiment of the present invention, the organic electronic device is an organic electroluminescent device or an organic photovoltaic device, preferably an organic light emitting diode, an organic transistor, or an organic diode.

The present invention furthermore relates to a display device comprising at least one organic electronic device according to the present invention, preferably at least two.

The present invention furthermore relates to a metal compound having a hygroscopy of ≤ 4%.

According to one embodiment of the present invention, the metal compound is capable of reducing the voltage of an organic light-emitting device at a certain current density when present.

According to one embodiment of the present invention, the metal compound has a hygroscopy of ≤ 3%, more preferably ≤ 2%, even more preferably ≤ 1%, even more preferably ≤ 0.5% by, most preferably ≤ 0.2%.

According to one embodiment of the present invention, the hygroscopy is the relative weight gain determined by gravimetric measurement of a vacuum dried sample of the metal compound, exposed to 70 ± 4 % relative humidity at 23 ± 2 °C for one hour.

The present invention furthermore relates to the use of a metal compound according to the present invention for the preparation of a p-type semiconducting layer.

### Further layers

In accordance with the invention, the organic electronic device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a backplane.

### Anode layer

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

### Hole injection layer

A hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL.

The HIL may comprise or consist of p-type dopant.

The p-type dopant concentrations can be selected from 1 to 20 wt.-%, more preferably from 3 wt.-% to 10 wt.-%.

The p-type dopant concentrations can be selected from 1 to 20 vol.-%, more preferably from 3 vol.-% to 10 vol.-%.

### Hole transport layer

According to one embodiment of the present invention, the organic electronic device comprises a hole transport layer, wherein the hole transport layer is arranged between the hole injection layer and the at least one first emission layer.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML

According to one embodiment of the present invention, the hole transport layer may comprise a substantially covalent matrix compound as described above.

According to one embodiment of the present invention, the hole transport layer may comprise a compound of formula (VI) or (VII) as described above.

According to one embodiment of the present invention, the hole injection layer and the hole transport layer comprises the same substantially covalent matrix compound as described above.

According to one embodiment of the present invention, the hole injection layer and the hole transport layer comprises the same compound of formula (VI) or (VII) as described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Emission layer (EML)

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML

According to one embodiment of the present invention, the emission layer does not comprise the metal compound of the present invention.

The emission layer (EML) may be formed of a combination of a host and an emitter dopant.

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The organic electronic device according to the present invention may further comprise an electron transport layer (ETL).

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

### Electron injection layer (EIL)

An optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode layer

The cathode layer is formed on the ETL or optional EIL. The cathode layer may be formed of a metal, an alloy, an electrically conductive compound, or a mixture thereof. The cathode electrode may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

It is to be understood that the cathode layer is not part of an electron injection layer or the electron transport layer.

### Organic light-emitting diode (OLED)

The organic electronic device according to the invention may be an organic light-emitting device.

According to one aspect of the present invention, there is provided an organic light-emitting diode (OLED) comprising: a substrate; an anode electrode formed on the substrate; a hole injection layer comprising a metal compound of the present invention, a hole transport layer, an emission layer, an electron transport layer and a cathode electrode.

According to another aspect of the present invention, there is provided an OLED comprising: a substrate; an anode electrode formed on the substrate; a hole injection layer comprising a metal compound of the present invention, a hole transport layer, an electron blocking layer, an emission layer, a hole blocking layer, an electron transport layer and a cathode electrode.

According to another aspect of the present invention, there is provided an OLED comprising: a substrate; an anode electrode formed on the substrate; a hole injection layer comprising a metal compound of the present invention, a hole transport layer, an electron blocking layer, an emission layer, a hole blocking layer, an electron transport layer, an electron injection layer, and a cathode electrode.

According to various embodiments of the present invention, there may be provided OLEDs layers arranged between the above mentioned layers, on the substrate or on the top electrode.

According to one aspect, the OLED may comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer, the n-type charge generation layer is adjacent arranged to a hole generating layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.

The organic semiconductor layer according to the invention may be the first hole injection layer and/or the p-type charge generation layer.

### Organic electronic device

The organic electronic device according to the invention may be a light emitting device, or a photovoltaic cell, and preferably a light emitting device.

According to another aspect of the present invention, there is provided a method of manufacturing an organic electronic device, the method using:
- at least one deposition source, preferably two deposition sources and more preferred at least three deposition sources.

The methods for deposition that can be suitable comprise:
- deposition via vacuum thermal evaporation;
- deposition via solution processing, preferably the processing is selected from spin-coating, printing, casting; and/or
- slot-die coating.

According to various embodiments of the present invention, there is provided a method using:
- a first deposition source to release the metal compound of according to the invention, and
- a second deposition source to release the substantially covalent matrix compound;
the method comprising the steps of forming the p-type semiconductor layer; whereby for an organic light-emitting diode (OLED):
- p-type semiconductor layer is formed by releasing the metal compound according to the invention from the first deposition source and the substantially covalent matrix compound from the second deposition source.

According to various embodiments of the present invention, the method may further include forming on the anode electrode, at least one layer selected from the group consisting of forming a hole transport layer or forming a hole blocking layer, and an emission layer between the anode electrode and the first electron transport layer.

According to various embodiments of the present invention, the method may further include the steps for forming an organic light-emitting diode (OLED), wherein
- on a substrate an anode electrode is formed,
- on the anode electrode a hole injection layer comprising a metal compound of the present invention,
- on the hole injection layer comprising a metal compound of the present invention a hole transport layer is formed,
- on the hole transport layer an emission layer is formed,
- on the emission layer an electron transport layer is formed, optionally a hole blocking layer is formed on the emission layer,
- and finally a cathode electrode is formed,
- optional a hole blocking layer is formed in that order between the first anode electrode and the emission layer,
- optional an electron injection layer is formed between the electron transport layer and the cathode electrode.

According to various embodiments, the OLED may have the following layer structure, wherein the layers having the following order:
anode, hole injection layer comprising a metal compound according to the invention, first hole transport layer, second hole transport layer, emission layer, optional hole blocking layer, electron transport layer, optional electron injection layer, and cathode.

According to another aspect of the invention, it is provided an electronic device comprising at least one organic light emitting device according to any embodiment described throughout this application, preferably, the electronic device comprises the organic light emitting diode in one of embodiments described throughout this application. More preferably, the electronic device is a display device.

Hereinafter, the embodiments are illustrated in more detail with reference to examples. However, the present disclosure is not limited to the following examples. Reference will now be made in detail to the exemplary aspects.

### Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.
FIG. 1 is a schematic sectional view of an organic electronic device, according to an exemplary embodiment of the present invention;
FIG. 2 is a schematic sectional view of an organic light-emitting diode (OLED), according to an exemplary embodiment of the present invention;
FIG. 3 is a schematic sectional view of an OLED, according to an exemplary embodiment of the present invention.
FIG. 4 is a schematic sectional view of an OLED, according to an exemplary embodiment of the present invention.
FIG. 5 is a schematic sectional view of an OLED, according to an exemplary embodiment of the present invention.
FIG. 6 is a schematic sectional view of an OLED comprising a charge generation layer, according to an exemplary embodiment of the present invention.
FIG. 7 is a schematic sectional view of a stacked OLED comprising a charge generation layer, according to an exemplary embodiment of the present invention.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

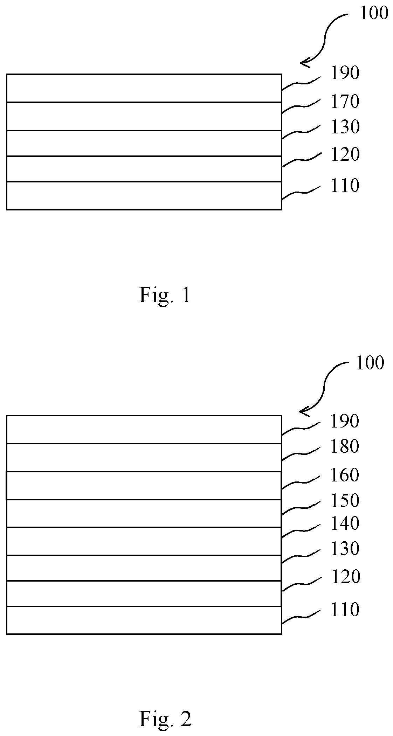

FIG. 1 is a schematic sectional view of an organic electronic device 100, according to an exemplary embodiment of the present invention. The organic electronic device 100 includes a substrate 110, an anode layer 120 and a hole injection layer (HIL) 130 which may comprise a metal compound of the present invention. The HIL 130 is disposed on the anode layer 120. Onto the HIL 130, a photoactive layer (PAL) 170 and a cathode layer 190 are disposed.

FIG. 2 is a schematic sectional view of an organic light-emitting diode (OLED) 100, according to an exemplary embodiment of the present invention. The OLED 100 includes a substrate 110, an anode layer 120 and a hole injection layer (HIL) 130 which may comprise a metal compound of the present invention. The HIL 130 is disposed on the anode layer 120. Onto the HIL 130, a hole transport layer (HTL) 140, an emission layer (EML) 150, an electron transport layer (ETL) 160, an electron injection layer (EIL) 180 and a cathode layer 190 are disposed. Instead of a single electron transport layer 160, optionally an electron transport layer stack (ETL) can be used.

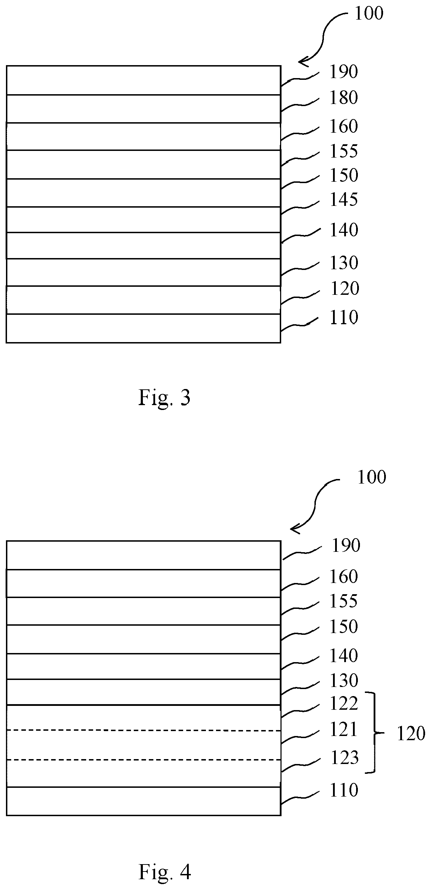

FIG. 3 is a schematic sectional view of an OLED 100, according to another exemplary embodiment of the present invention. Fig. 3 differs from Fig. 2 in that the OLED 100 of Fig. 3 comprises an electron blocking layer (EBL) 145 and a hole blocking layer (HBL) 155.

Referring to Fig. 3, the OLED 100 includes a substrate 110, an anode layer 120, a hole injection layer (HIL) 130 which may comprise a metal compound of the present invention, a hole transport layer (HTL) 140, an electron blocking layer (EBL) 145, an emission layer (EML) 150, a hole blocking layer (HBL) 155, an electron transport layer (ETL) 160, an electron injection layer (EIL) 180 and a cathode layer 190.

FIG. 4 is a schematic sectional view of an organic electronic device 100, according to an exemplary embodiment of the present invention. The organic electronic device 100 includes a substrate 110, an anode layer 120 that comprises a first anode sub-layer 121, a second anode sub-layer 122 and a third anode sub-layer 123, and a hole injection layer (HIL) 130. The HIL 130 is disposed on the anode layer 120. Onto the HIL 130, an hole transport layer (HTL) 140, a first emission layer (EML) 150, a hole blocking layer (HBL) 155, an electron transport layer (ETL) 160, and a cathode layer 190 are disposed. The hole injection layer 130 may comprise a metal compound of the present invention.

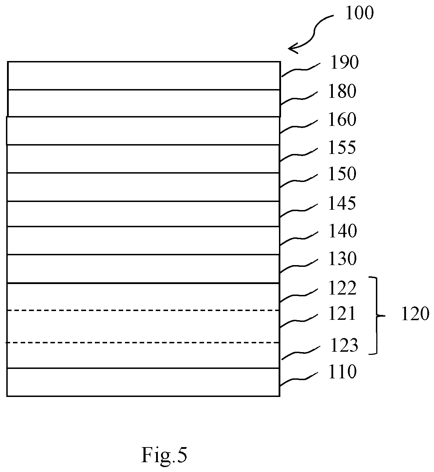

FIG. 5 is a schematic sectional view of an organic electronic device 100, according to an exemplary embodiment of the present invention. The organic electronic device 100 includes a substrate 110, an anode layer 120 that comprises a first anode sub-layer 121, a second anode sub-layer 122 and a third anode sub-layer 123, and a hole injection layer (HIL) 130. The HIL 130 is disposed on the anode layer 120. Onto the HIL 130, a hole transport layer (HTL) 140, an electron blocking layer (EBL) 145, a first emission layer (EML) 150, a hole blocking layer (HBL) 155, an electron transport layer (ETL) 160, an electron injection layer (EIL) 180 and a cathode layer 190 are disposed. The hole injection layer 130 may comprise a metal compound of the present invention.

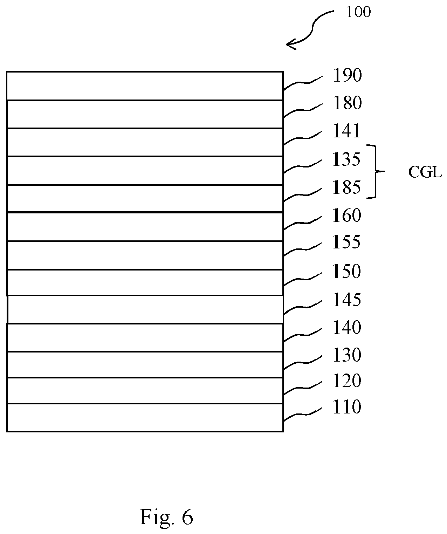

Referring to Fig. 6 the organic electronic device 100 includes a substrate 110, an anode layer 120, a hole injection layer (HIL) 130, a first hole transport layer (HTL1) 140, an electron blocking layer (EBL) 145, an emission layer (EML) 150, a hole blocking layer (HBL) 155, an electron transport layer (ETL) 160, an n-type charge generation layer (n-CGL) 185, a p-type charge generation layer (p-GCL) 135 which may comprise a metal compound of the present invention, a second hole transport layer (HTL2) 141, and electron injection layer (EIL) 180 and a cathode layer 190. The HIL may also comprise a metal compound of the present invention.

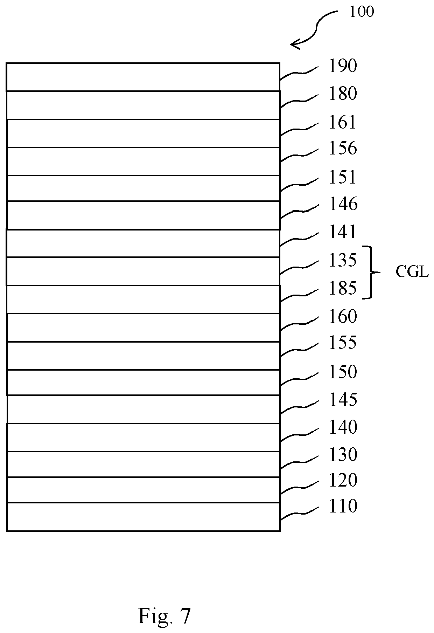

Referring to Fig. 7 the organic electronic device 100 includes a substrate 110, an anode layer 120, a hole injection layer (HIL) 130, a first hole transport layer (HTL) 140, a first electron blocking layer (EBL) 145, a first emission layer (EML) 150, an optional first hole blocking layer (HBL) 155, a first electron transport layer (ETL) 160, an n-type charge generation layer (n-CGL) 185, a p-type charge generation layer (p-GCL) 135 which may comprise metal compound of the present invention, a second hole transport layer (HTL) 141, a second electron blocking layer (EBL) 146, a second emission layer (EML) 151, an optional second hole blocking layer (HBL) 156, a second electron transport layer (ETL) 161, an electron injection layer (EIL) 180 and a cathode layer 190. The HIL may also comprise a metal compound of the present invention.

While not shown in Fig. 1 to Fig. 7, a capping and/or sealing layer may further be formed on the cathode layer 190, in order to seal the organic electronic device 100. In addition, various other modifications may be applied thereto.

Hereinafter, one or more exemplary embodiments of the present invention will be described in detail with, reference to the following examples. However, these examples are not intended to limit the purpose and scope of the one or more exemplary embodiments of the present invention.

### Detailed description

### Determination of the hygroscopicity by gravimetric measurement

To a test chamber, containing a saturated solution of 40g NaCl in 100 ml deionized watera thermometer and a hygrometer is connected. Temperature and humidity inside the test chamber and outside in the lab are recorded. The humidity created by the statured NaCl solution inside test chamber reached 70±4% RH (relative humidity). Lab temperature was maintained at 23±2°C.

An empty Al pan was balanced as a reference. An additional empty pan was balanced and 10,000 to 14,000 mg sublimed metal compound powder was placed into this pan. The sample was evenly spread inside the pan.

The empty pan and pan with sample were both exposed into the test chamber, by means of a small plastic tray which floats on the NaCl solution.

After 1 h, both pans were taken out, balanced immediately and their mass was recorded. The empty reference pan should did not significantly change its mass during the experiment. The difference in mass for the sample pan prior versus after exposure in the test chamber was recorded and expressed as change in w%.

Remark: Material for hygroscopicity testing was dry material prepared by high vacuum sublimation of the respective organic metal complex. Sublimed material was collected in a dry box and air and moisture access was prevented before hygroscopicity test.

Table 1 shows the measured hygroscopy for comparative compounds C1 and C2 and inventive compounds E1 to E32. The compounds are all capable of reducing the voltage of an organic light-emitting device at a certain current density when present.

By having such a low hygroscopy, compounds E1 to E32 enabled a more robust process for production of organic electronic devices with excellent properties, when compared to C1 or C2.

**Table 1:**

| Compound | Structure | Name | Hygroscopy |
|---|---|---|---|
| C1 | 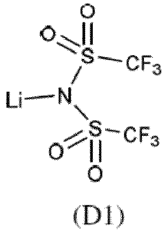 | lithium bis((trifluoromethyl)sulfonyl)amide | 50% |
| C2 | 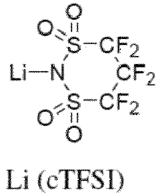 | lithium 4,4,5,5,6,6-hexafluoro-1,3,2-dithiazinan-2-ide 1,1,3,3-tetra oxide | 40% |
| E1 | 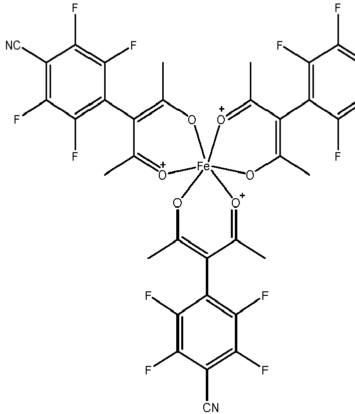 | Tris(3-(4-cyano-2,3,5,6-tetrafluorophenyl)-2,4-pentanedionato)iron(III) | 0% |
| E2 | 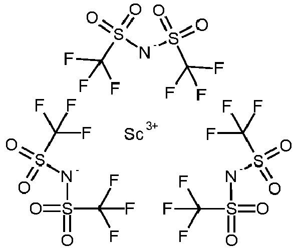 | Scandium(III) bistriflylimide | 0.14% |
| E3 | 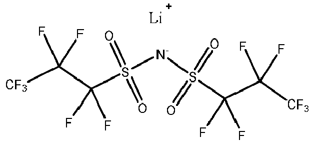 | lithium bis((perfluoropropyl)sulfonyl)amide | 2.9% |
| E4 | 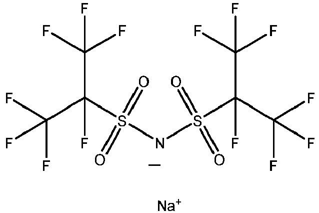 | sodium bis((perfluoropropan-2-yl)sulfonyl)amide | 1.1% |
| E5 | 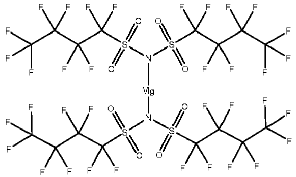 | magnesium bis((perfluorobutyl)sulfonyl)amide | 3.7% |
| E6 | 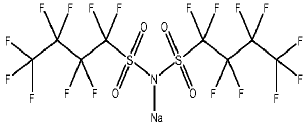 | 1-Butanesulfonamide,1,1,2,2,3,3,4,4,4-nonafluoro-*N-*[(1,1,2,2,3,3,4,4,4-nonafluorobutyl)sulfonyl]-, sodium salt | 0% |
| E7 | 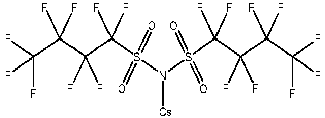 | 1-Butanesulfonamide,1,1,2,2,3,3,4,4,4-nonafluoro-*N-*[(1,1,2,2,3,3,4,4,4-nonafluorobutyl)sulfonyl]-, Cesium salt | 0% |
| E8 | 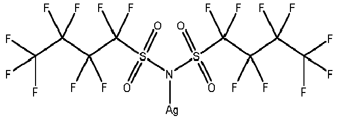 | 1-Butanesulfonamide,1,1,2,2,3,3,4,4,4-nonafluoro-*N-*[(1,1,2,2,3,3,4,4,4-nonafluorobutyl)sulfonyl]-, silver | 0% |
| E9 | 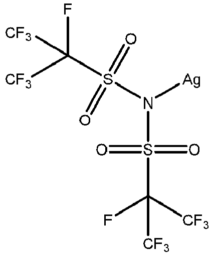 | ((1,1,1,2,3,3,3-heptafluoro-N-((perfluoropropan-2-yl)sulfonyl)propan-2-yl)sulfonamido)silver | 2.2% |
| E10 | 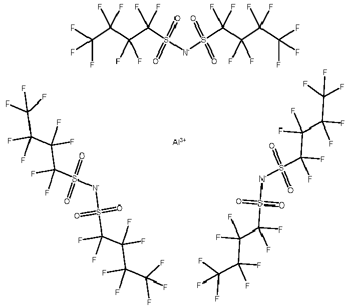 | aluminium tris(bis(perfluorobutyl)sulfo nyl)amide) | 0.8% |
| E11 | 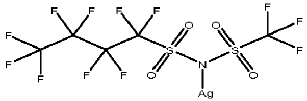 | ((1,1,2,2,3,3,4,4,4-nonafluoro-N-((trifluoromethyl)sulfonyl)b utyl)sulfonamido)silver | 3.4% |
| E12 | 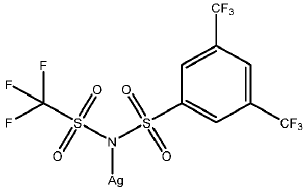 | ((3,5-bis(trifluoromethyl)-N-((trifluoromethyl)sulfonyl)phenyl)sulfonamido)silver | 1.4% |
| E13 | 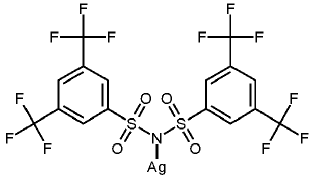 | ((N-((2,4-bis(trifluoromethyl)phenyl)sulfinyl)-3,5-bis(trifluoromethyl)phenyl)sulfonamido)silver | 2.4% |
| E14 | 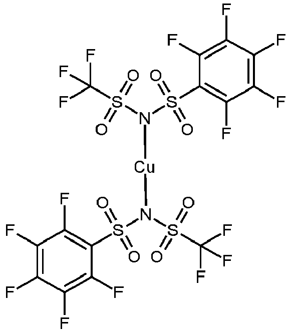 | bis((1,1,1-trifluoro-N-((perfluorophenyl)sulfinyl)methyl)sulfonamido)copper | 3.7% |
| E15 | 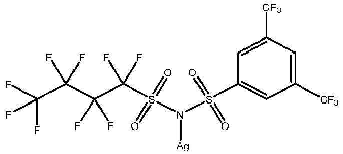 | ((N-((perfluorobutyl)sulfonyl)-3,5-bis(trifluoromethyl)phenyl)sulfonamido)silver | 0.1% |
| E16 | 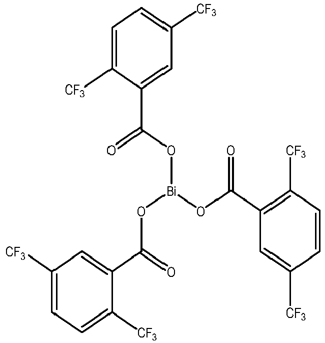 | bismuthanetriyltris(oxy))tris((2,5-bis(trifluoromethyl)phenyl) methanone) | 0.8% |
| E17 | 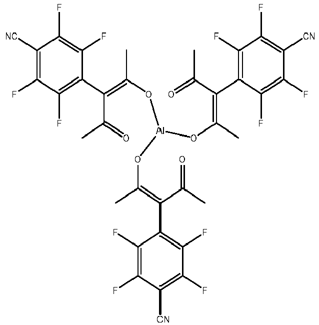 | tris(((Z)-3-(4-cyano-2,3,5,6-tetrafluorophenyl)-4-oxopent-2-en-2-yl)oxy)aluminum | 0% |
| E18 | 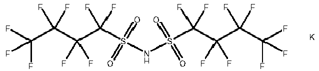 | 1,1,2,2,3,3,4,4,4-nonafluoro-N-((perfluorobutyl)sulfonyl)bu tane-1-sulfonamide,potassium salt | 0% |
| E19 | 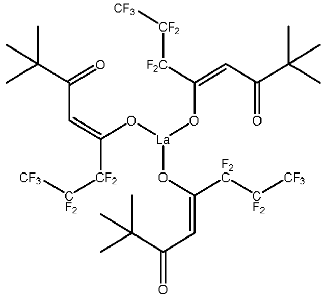 | tris(((Z)-1,1,1,2,2,3,3-heptafluoro-7,7-dimethyl-6-oxooct-4-en-4-yl)oxy)lanthanum | 0.2% |
| E20 | 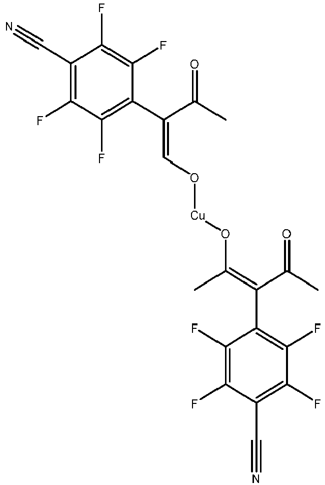 | (((Z)-2-(4-cyano-2,3,5,6-tetrafluorophenyl)-3-oxobut-1-en-1-yl)oxy)(((Z)-3-(4-cyano-2,3,5,6-tetrafluorophenyl)-4-oxopent-2-en-2-yl)oxy)copper | 0% |
| E21 | 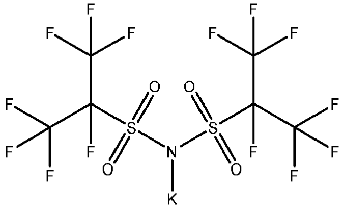 | potassium bis((perfl uoropropan-2-yl)sulfonyl)amide | 0% |
| E22 | 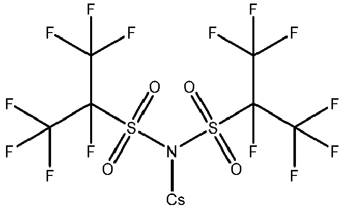 | cesium bis((perfluoropropan-2-yl)sulfonyl)amid | 0% |
| E23 | 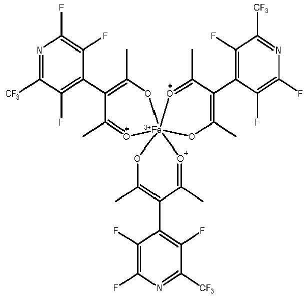 | tris(((Z)-4-oxo-3-(2,3,5-trifluoro-6-(trifluoromethyl)pyridin-4-yl)pent-2-en-2-yl)oxy)iron | 0% |
| E24 | 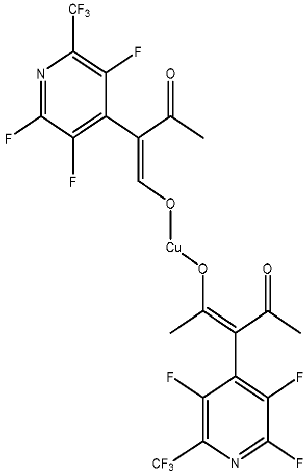 | (((Z)-3-oxo-2-(2,3,5-trifluoro-6-(trifluoromethyl)pyridin-4-yl)but-1-en-1-yl)oxy)(((Z)-4-oxo-3-(2,3,5-trifluoro-6-(trifluoromethyl)pyridin-4-yl)pent-2-en-2-yl)oxy)copper | 0% |
| E25 | 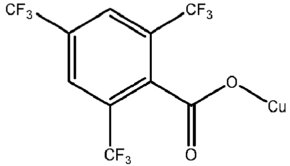 | ((2,4,6-tris(trifluoromethyl)benzoyl)oxy)copper | 0% |
| E26 | 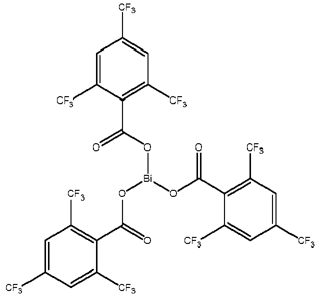 | (bismuthanetriyltris(oxy))tris((2,4,6-tris(trifluoromethyl)phenyl)methanone) | 0.2% |
| E27 | 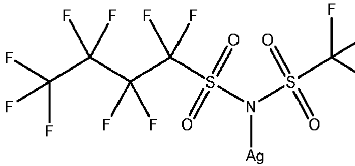 | ((1,1,2,2,3,3,4,4,4-nonafluoro-N-((perfluoropropan-2-yl)sulfonyl)butyl)sulfonamido)silver | 3% |
| E28 | 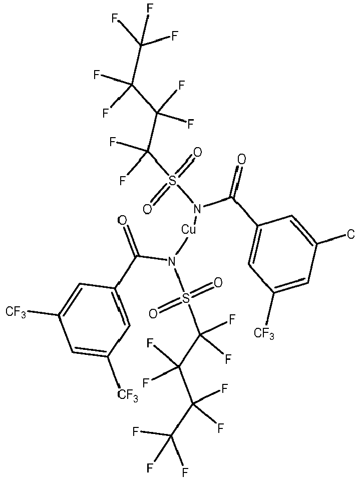 | bis(N-((perfluorobutyl)sulfonyl)-3,5-bis(trifluoromethyl)benzamido)copper | 0.8% |
| E29 | 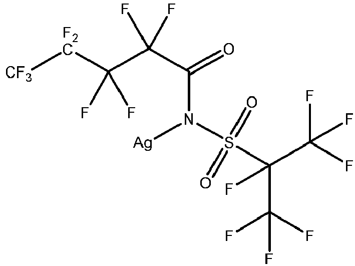 | (2,2,3,3,4,4,5,5,5-nonafluoro-N-((perfluoropropan-2-yl)sulfonyl)pentanamido)silver | 0.1% |
| E31 | 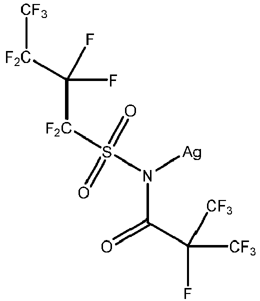 | (2,3,3,3-tetrafluoro-N-((perfluorobutyl)sulfonyl)-2-(trifluoromethyl)propanamido)silver | 0% |
| E32 | 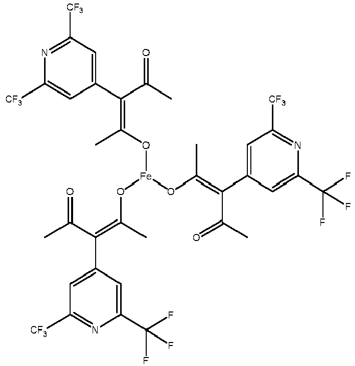 | tris(((Z)-3-(2,6-bis(trifluoromethyl)pyridin-4-yl)-4-oxopent-2-en-2-yl)oxy)iron | 0% |

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

1. Method for preparation of a p-type semiconducting layer, the method comprising at least the following steps:
(a) Providing a surface;
(b) Providing p-type semiconducting material comprising a metal compound, the metal compound having a hygroscopy of ≤ 4%;
(c) Evaporating the metal compound at a reduced pressure;
(d) Depositing the evaporated metal compound on the surface.

2. Method according to claim 1, wherein the metal compound has a relative water content due to sorption of ≤ 4% by weight.

3. Method according to any one of claims 1 or 2, wherein the metal compound is air stable.

4. Method according to any one of claims 1 to 3, wherein at least 20 % of the overall number of peripheral atoms present in the metal compound are independently selected from F, Cl, Br, I and N, preferably from F and N, wherein peripheral atoms are all atoms which are covalently bound to a single neighbour atom.

5. Method according to any one of the claims 1 to 4, wherein the metal compound comprises a metal in an oxidation state of +I and a monoanionic ligand.

6. Method according to any one of the claims 1 to 5, wherein the metal compound comprises at least one ligand, and the ligand, consists of elements selected from from H, F, Cl, Br, I, C, Si, O, S, N and P.

7. Method according to any one of the claims 1 to 6, wherein the p-type semiconducting material further comprises a substantially covalent matrix compound.

8. P-type semiconducting layer, obtained by the method according to any one of claims 1 to 7.

9. P-type semiconducting layer according to claim 8, wherein the p-type semiconducting layer is a hole injection layer, a hole transport layer or a hole generating layer.

10. Organic electronic device comprising an anode layer, a cathode layer, at least one p-type semiconducting layer according to claim 9, and at least one photoactive layer, wherein the at least one photoactive layer is arranged between the anode layer and the cathode layer,

11. Organic electronic device according to claim 10, wherein the organic electronic device comprises a first light emitting layer and a second light emitting layer as photoactive layers, wherein the p-type semiconducting layer is a hole generating layer arranged between the first light emitting layer and the second light emitting layer.

12. The organic electronic device according to any one of claims 10 or 11, wherein the organic electronic device is an organic electroluminescent device or an organic photovoltaic device.

13. A display device comprising at least one organic electronic device according to any one of the claims 10 or 12.

14. Metal compound having a hygroscopy of ≤ 4%, wherein the hygroscopy is the relative weight gain determined by gravimetric measurement of a vacuum dried metal compound sample exposed to 70 ± 4 % relative humidity at 23 ± 2 °C for one hour.

15. Use of a metal compound according to claim 14 for the preparation of a p-type semiconducting layer.
